(19) Europäisches Patentamt
European Patent Office
Office européen des brevets

(11) **EP 3 196 972 A1**

(12) **EUROPEAN PATENT APPLICATION**
published in accordance with Art. 153(4) EPC

(43) Date of publication:
26.07.2017 Bulletin 2017/30

(51) Int Cl.:
*H01M 10/48* (2006.01)   *G01K 1/14* (2006.01)
*G01R 15/14* (2006.01)   *G01R 31/36* (2006.01)

(21) Application number: 15841571.1

(22) Date of filing: 08.09.2015

(86) International application number:
PCT/JP2015/004540

(87) International publication number:
WO 2016/042732 (24.03.2016 Gazette 2016/12)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(30) Priority: 16.09.2014 JP 2014187623

(71) Applicant: Panasonic Intellectual Property
Management Co., Ltd.
Osaka-shi, Osaka 570-6207 (JP)

(72) Inventor: KIMURA, Shinya
Osaka-shi
Osaka 540-6207 (JP)

(74) Representative: Schwabe - Sandmair - Marx
Patentanwälte Rechtsanwalt
Partnerschaft mbB
Joseph-Wild-Straße 20
81829 München (DE)

(54) **BATTERY SENSOR DEVICE**

(57) A battery sensor device includes a terminal, bus bars, a board, a temperature sensor, and a heat transfer member. The terminal includes a clamp part fitted to a terminal of the battery. A load-side terminal is installed on one of the bus bars. The bus bars electrically connect the clamp part and the load-side terminal via a shunt resistance. The board is electrically connected to the bus bars to overlap the bus bars, and includes a protruding part which protrudes from the bus bars toward the clamp part. The temperature sensor is installed on the protruding part of a surface which faces the bus bars of the board. The heat transfer member is provided between the temperature sensor and the terminal.

FIG. 15

EP 3 196 972 A1

**Description**

TECHNICAL FIELD

The present invention relates to a battery sensor device for detecting a state of a battery.

BACKGROUND ART

Detection of a battery capacity (SOC: State of Charge) or a battery deterioration state (SOH: State of Health) of a battery (for example, a lead battery) mounted on a vehicle is performed. In order to detect the SOC or the SOH, it is necessary to detect a voltage, a current and a temperature of the battery, and a battery sensor device for detecting these is disclosed in, for example, Patent Literature 1 and Patent Literature 2.

Patent Literature 1 discloses a battery sensor device capable of accurately detecting the temperature of a battery by providing a temperature sensor which detects the temperature of a battery close to a terminal of the battery.

Patent Literature 2 discloses a battery sensor device capable of accurately detecting the temperature of a battery by directly providing a temperature sensor which detects the temperature of the battery on the terminal body.

Citation List

Patent Literature

PTL 1: Japanese Patent No. 4494895
PTL 2: Japanese Patent No. 4996802

SUMMARY OF THE INVENTION

The present invention provides a battery sensor device capable of accurately detecting a temperature of a battery and having excellent assembling properties.

A battery sensor device according to a first aspect of the present invention includes a terminal, bus bars, a board, a temperature sensor, and a heat transfer member. The terminal includes a clamp part fitted to a terminal of the battery. A load-side terminal is installed on the bus bars. The bus bars electrically connect the clamp part and the load-side terminal via a shunt resistance. The board is electrically connected to the bus bars to overlap the bus bars, and includes a protruding part which protrudes from the bus bars toward the clamp part. The temperature sensor is installed on the protruding part of a surface which faces the bus bars of the board. The heat transfer member is provided between the temperature sensor and the terminal.

A battery sensor device according to a second aspect of the present invention includes a clamp part which is fitted to a terminal of a battery, a load-side terminal, bus bars, a temperature sensor which detects a temperature, a board, and a sealer. The bus bars electrically connect the clamp part and the load-side terminal via a shunt resistance. The temperature sensor is installed on the board. The board is fastened to the metal part between the clamp part and the shunt resistance. The sealer covers the board. The temperature sensor is installed on the board to be separated from the metal part. The fastener between the board and the metal part is disposed outside the first circle which is centered on the center of the clamp part, and which has the shortest distance from the center of the clamp part to the sealer as a radius. The fastener is disposed inside a second circle which is centered on the center of the clamp part and which has a distance as a radius obtained by adding a length three times the maximum bearing surface width of the fastener to the shortest distance from the center of the clamp part to the sealer. Alternatively, the fastener is disposed inside the second circle which has a distance as a radius obtained by adding a length three times the maximum width of the contact surface between the board and the metal part in the fastener, to a shortest distance from the center of the clamp part to the sealer.

According to the present invention, it is possible to provide a battery sensor device capable of accurately detecting a temperature of a battery and having excellent assembling properties.

BRIEF DESCRIPTION OF DRAWINGS

FIG. 1 is a perspective diagram illustrating a state in which a battery sensor device according to exemplary embodiment 1 of the present invention is connected to a battery.

FIG. 2 is a top surface diagram illustrating a state in which the battery sensor device according to exemplary embodiment 1 of the present invention is connected to the battery.

FIG. 3 is an exploded perspective diagram illustrating a state before bus bars and a shunt resistance are attached to a terminal.

FIG. 4 is a perspective diagram illustrating a state in which the bus bars and the shunt resistance are attached to the terminal.

FIG. 5 is a top surface diagram illustrating a state in which the bus bar and the shunt resistance are attached to the terminal.

FIG. 6 is a plan view illustrating a first surface of a board.

FIG. 7 is an enlarged diagram illustrating a configuration example of region A of FIG. 6.

FIG. 8 is an enlarged diagram illustrating another configuration example of region A of FIG. 6.

FIG. 9 is a top surface diagram illustrating a state in which the board is attached to the terminal.

FIG. 10 is an enlarged diagram of region B of FIG. 9.

FIG. 11 is a sectional diagram taken along a C-C line of FIG. 10.

FIG. 12 is a top surface diagram illustrating a state in which a resin mold is formed on the battery sensor device illustrated in FIG. 9.

FIG. 13 is a perspective diagram illustrating a configuration of the battery sensor device as viewed from above.

FIG. 14 is a perspective diagram illustrating a configuration of the battery sensor device as viewed from below.

FIG. 15 is a diagram illustrating a range of a board fastening point.

FIG. 16 is an enlarged diagram of region D in FIG. 15, which is a diagram for explaining the range of the disposition position of a thermistor.

FIG. 17 is a perspective diagram illustrating a configuration of a battery sensor device according to exemplary embodiment 2 of the present invention.

FIG. 18 is a perspective diagram illustrating a configuration of the battery sensor device illustrated in FIG. 17 after a resin mold is formed.

FIG. 19 is a top surface diagram illustrating the configuration of the battery sensor device illustrated in FIG. 17 after the resin mold is formed.

FIG. 20 is a top surface diagram illustrating the configuration of the battery sensor device illustrated in FIG. 17 after the board is caused to overlap.

FIG. 21 is a sectional diagram taken along an E-E line of FIG. 19.

FIG. 22 is an enlarged diagram of region F of FIG. 21.

FIG. 23 is a diagram illustrating a state after a heat transfer member is filled and the board is caused to overlap in FIG. 22.

DESCRIPTION OF EMBODIMENTS

Before describing exemplary embodiments of the present invention, a concise description will be given of the problems in the battery sensor device of the related art.

In the battery sensor device disclosed in Patent Literature 1, since the temperature sensor and the board are connected by lead wires, assembly is difficult.

In the battery sensor device disclosed in Patent Literature 2, since it is necessary to provide a structure (for example, a structure or the like to be fixed via an elastic body) for bringing the temperature sensor into close contact with the terminal body, the structure becomes complicated.

Hereinafter, detailed description will be given of the exemplary embodiments of the present invention with reference to the drawings.

(Exemplary Embodiment 1)

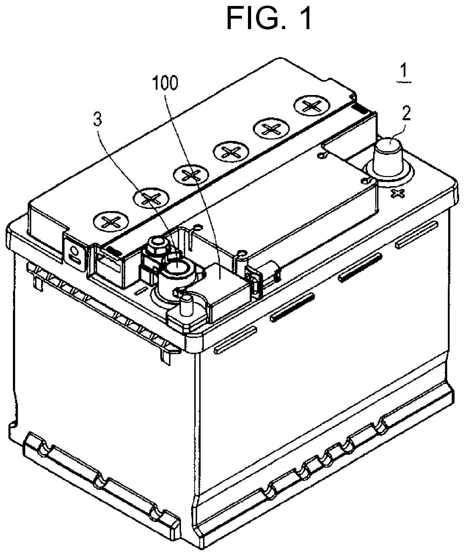

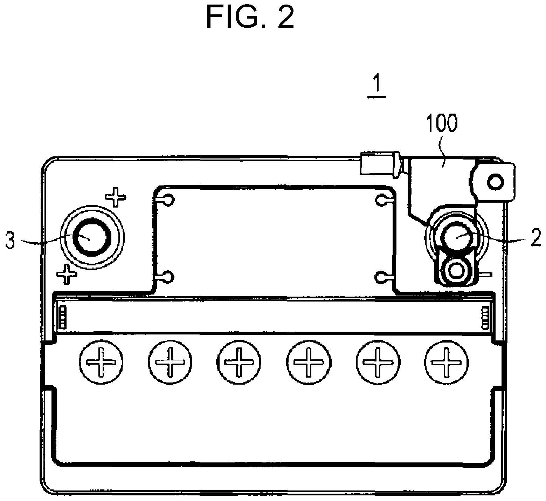

FIG. 1 is a perspective diagram illustrating a state in which battery sensor device 100 according to exemplary embodiment 1 of the present invention is connected to battery 1. FIG. 2 is a top surface diagram of FIG. 1.

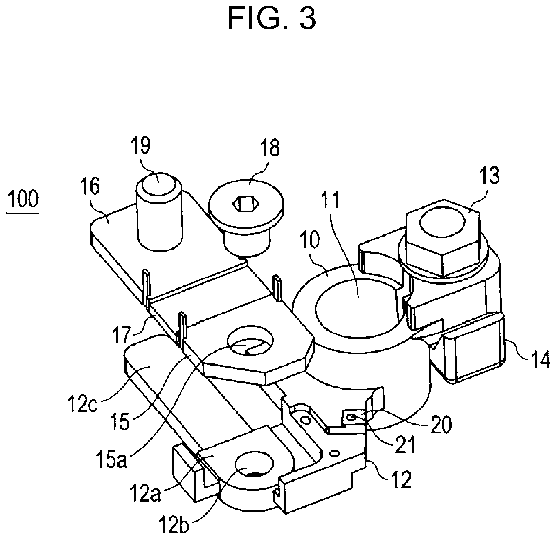

As illustrated in FIGS. 1 and 2, battery 1 is provided with plus terminal 2 and minus terminal 3. In battery sensor device 100, clamp part 11 (refer to FIG. 3) which is described later is fitted to minus terminal 3, and is fastened to minus terminal 3 by nut 13 and bolt 14 (refer to FIG. 3) which are described later.

Hereinafter description will be given of the specific configuration of battery sensor device 100.

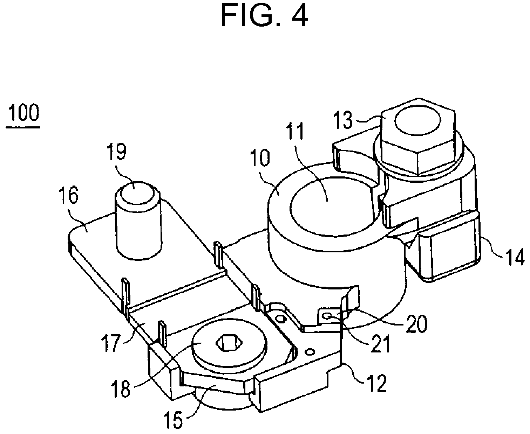

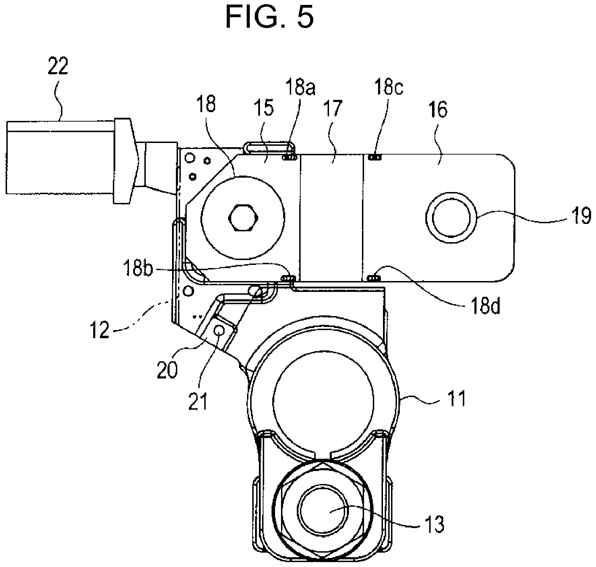

FIG. 3 is an exploded perspective diagram illustrating a state before attaching bus bars 15 and 16 and shunt resistance 17 to terminal 10. FIG. 4 is a perspective diagram illustrating a state in which bus bars 15 and 16 and shunt resistance 17 are attached to terminal 10. FIG. 5 is a top surface diagram of FIG. 4.

In FIG. 3, terminal 10 (an example of a metal part) is formed of a metal member such as brass, for example, and includes clamp part 11 and attachment part 12. As illustrated in FIG. 3, attachment part 12 protrudes from the side surface of clamp part 11 and is joined to clamp part 11. The metal member which forms terminal 10 is not limited to brass and may be another metal.

Clamp part 11 is fitted to minus terminal 3 of battery 1. Clamp part 11 grips minus terminal 3 of battery 1 to fasten by interposing clamp part 11 using bolt 13 and nut 14.

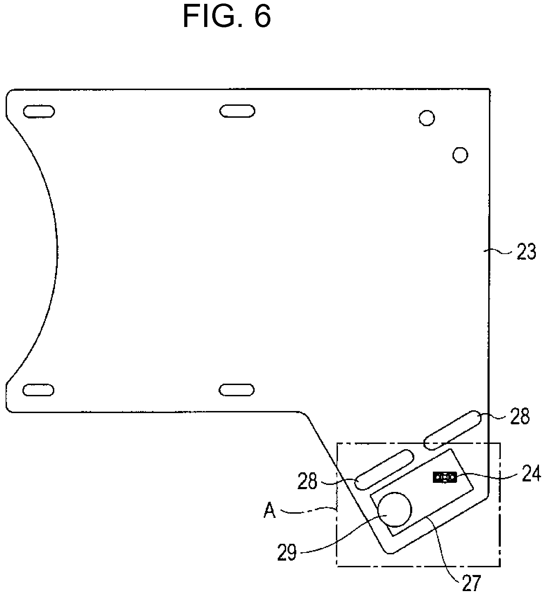

Bus bars 15 and 16, shunt resistance 17, and board 23 (refer to FIG. 6) are attached to attachment part 12. A current from the battery 1 flows via terminal 10 to bus bar 15, shunt resistance 17, and bus bar 16. Hole portion 15a through which bolt 18 is inserted is formed in bus bar 15. In the present exemplary embodiment, bus bar 15 is fastened to attachment part 12 of terminal 10 by bolt 18; however, the configuration is not limited thereto. For example, bus bar 15 may be electrically and mechanically connected to attachment part 12 of terminal 10 by welding, caulking, rivets, or the like.

Bus bar 16 is provided with, for example, vehicle load-side terminal 19 which is grounded to a body (not illustrated) of the vehicle. Shunt resistance 17 is provided between bus bar 15 and bus bar 16.

As illustrated in FIG. 3, joint portion 12a which joins attachment part 12 to bus bar 15 is formed on attachment part 12. Hole portion 12b is formed in joint portion 12a. By inserting bolt 18 into hole portion 12b of joint portion 12a and hole portion 15a of bus bar 15, bus bar 15 is attached in contact with joint portion 12a as illustrated in FIGS. 4 and 5. Joint portion 12a is formed of metal.

As illustrated in FIG. 3, support portion 12c which is adjacent to joint portion 12a is provided on attachment part 12. Support portion 12c is a portion of terminal 10, and is a conductor. There is a gap between support portion 12c and bus bar 16, and support portion 12c is not electrically connected to bus bar 16. Support portion 12c is integrated with resin mold 31 when resin mold 31 which is described later is molded, and serves a role of holding bus bar 16. Since support portion 12c increases the mechanical reliability, there is not influence on the temperature measurement.

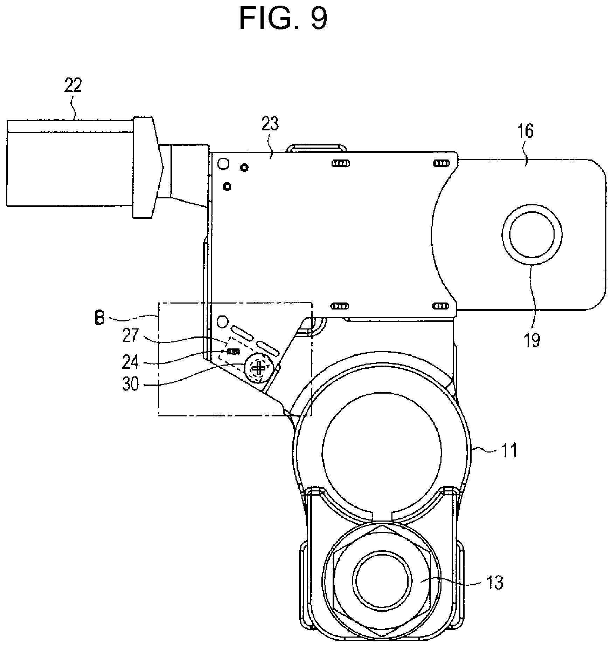

As illustrated in FIG. 3, joint portion 20 which joins attachment part 12 to board 23 is formed on attachment part 12. Hole portion 21 through which screw 30 (refer to FIG. 9) which is described later is inserted is formed in joint portion 20. Joint portion 20 is formed of metal. Detailed description of the attachment of board 23 to joint portion 20 will be given later.

Although not illustrated in FIGS. 3 and 4, as illustrated in FIG. 5, connector portion 22 is attached to attachment part 12. Connector portion 22 is connected to plus terminal 2 of battery 1 (not illustrated). Connector portion 22 outputs information indicating a current, a voltage, a temperature, and the like which are detected by board 23 which is described later to a CPU (Central Processing Unit), an ECU (Engine Control Unit), or the like, which is not illustrated.

After bus bars 15 and 16 and shunt resistance 17 are attached to attachment part 12 as illustrated in FIGS. 4 and 5, board 23 is fastened to joint portion 20 of attachment part 12. At this time, board 23 is connected to current detection terminals 18a to 18d which are connected to bus bars 15 and 16. Accordingly, board 23 detects a voltage difference across shunt resistance 17. In FIG. 5, bus bars 15 and 16 are provided with two current detection terminals each for a total of four current detection terminals; however, a total of two current detection terminals may be provided, one each before and after shunt resistance 17. In other words, either current detection terminal 18a or the current detection terminal 18b may be provided on bus bar 15, and either current detection terminal 18c or current detection terminal 18d may be provided on bus bar 16.

Here, description will be given of board 23. FIG. 6 is a plan view illustrating a first surface of board 23. The first surface refers to a surface of the side which faces attachment part 12 when board 23 is attached to attachment part 12.

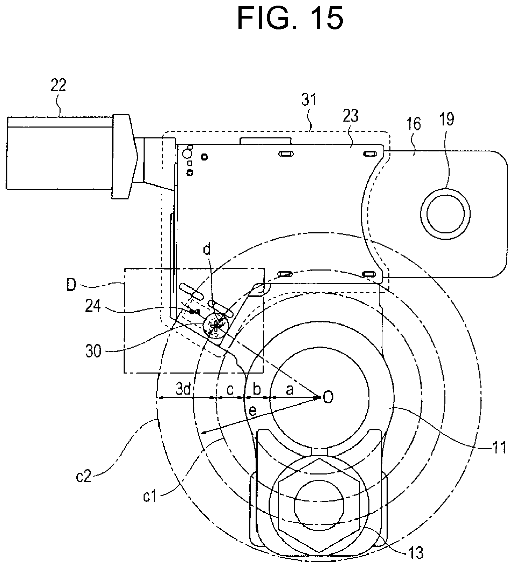

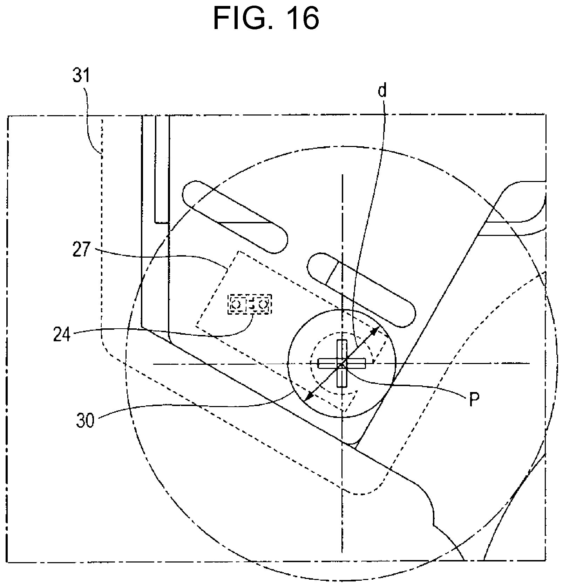

Board 23 is, for example, a glass epoxy board-shaped member. As illustrated in FIGS. 6 and 9, board 23 has a shape protruding to clamp part 11 side, and on the first surface of the projecting portion, thermistor 24 is attached as a temperature sensor for measuring the temperature of battery 1. Thermistor 24 is less susceptible to the influence of the temperature of shunt resistance 17 and is disposed in a position closer to minus terminal 3 in order to enable more accurate temperature detection. Details of the disposition position of thermistor 24 will be described later using FIGS. 15 and 16.

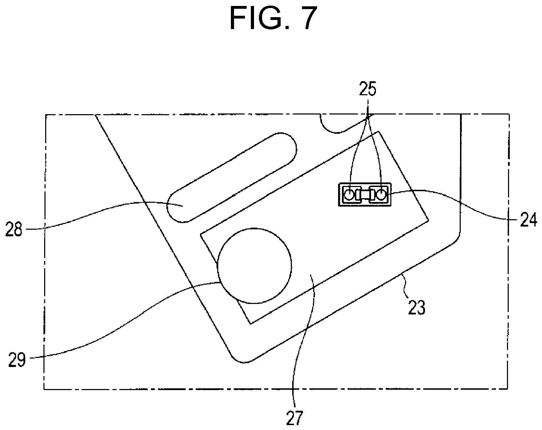

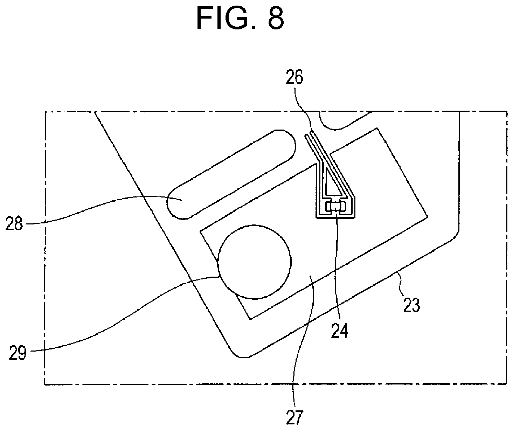

Information of the temperature which is detected by thermistor 24 is output to an output circuit (not illustrated) which is provided on board 23, for example, by the electrical wiring illustrated in FIG. 7 or 8. FIGS. 7 and 8 are enlarged diagrams of region A of FIG. 6.

In the example of FIG. 7, via 25 which communicates with the inside of board 23 is formed, and the information of the temperature which is measured by thermistor 24 is output via via 25 and a wiring (not illustrated) which is inside board 23 which is connected to via 25, and is output to the circuit.

On the other hand, in the example of FIG. 8, electric pattern (pattern wiring) 26 is formed on board 23, and the information of the temperature which is measured by thermistor 24 is output to an output circuit via electric pattern 26 and a wiring (not illustrated) on the first surface of board 23 which is connected to electric pattern 26.

The output circuit outputs information of the temperature which is input from thermistor 24 to the CPU, the ECU, or the like via connector portion 22.

In addition to thermistor 24 which is described above, board 23 includes a voltage sensor (not illustrated) which detects the voltage of battery 1, and current sensor (not illustrated) which detects the current based on the voltage across both terminals of shunt resistance 17. Information of the voltage and the current which are detected by these sensors is also output to the CPU, the ECU, or the like via the output circuit and connector portion 22.

As illustrated in FIG. 6, thermal conduction pattern 27 (heat transfer member) is formed on the first surface of board 23. Thermal conduction pattern 27 is formed of a member (for example, copper foil) having a thermal conductivity higher than that of board 23.

For example, as illustrated in FIG. 7, thermal conduction pattern 27 is formed close to thermistor 24 so as not to come into contact with thermistor 24. In the same manner in the case of FIG. 8, thermal conduction pattern 27 is formed close to thermistor 24 and electric pattern 26 so as not to come into contact with thermistor 24 and electric pattern 26. In other words, a clearance of a predetermined length is provided between thermal conduction pattern 27 and thermistor 24.

Thermal conduction pattern 27 may be formed to extend along at least one side of thermistor 24. The length of the clearance between thermistor 24 and thermal conduction pattern 27 may be shorter than the shortest width among the widths in the planar direction of thermistor 24. In the present exemplary embodiment, thermal conduction pattern 27 and ground (GND) of thermistor 24 are separated. However, by making thermal conduction pattern 27 and GND of thermistor 24 match circuit-wise, it is also possible to eliminate the clearance therebetween and to render thermal conduction pattern 27 and the ground pattern of thermistor 24 common.

As illustrated in FIG. 6, pattern cut portion 28 in which a portion of board 23 is cut out is formed on board 23. Pattern cut portion 28 prevents the heat from shunt resistance 17 from transferring to thermistor 24. The thermal capacity of the area of board 23 on which thermistor 24 rests is reduced, and the responsiveness of the temperature is increased.

As illustrated in FIG. 6, hole portion 29 through which screw 30 (refer to FIG. 5) (heat transfer member) which is described later is inserted is formed in board 23.

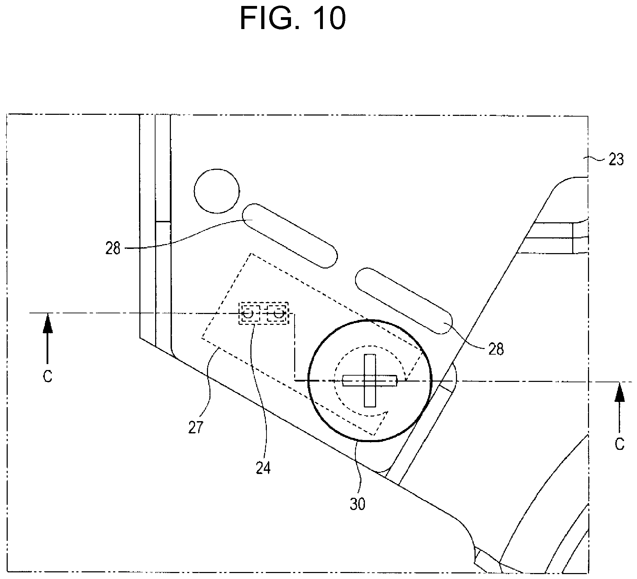

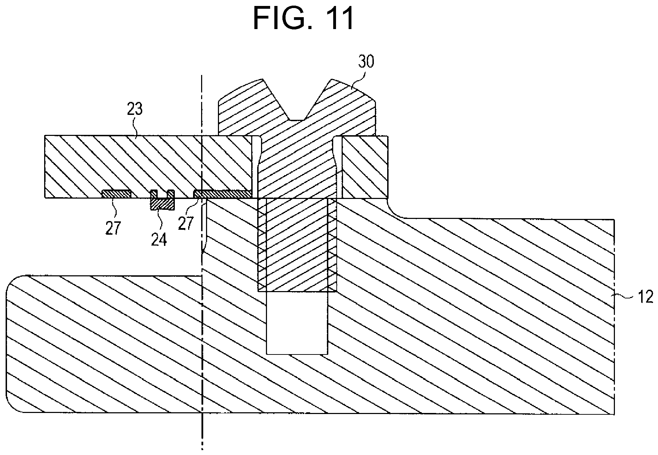

The first surface of board 23, which is configured in this manner, is fixed by a screw while facing attachment part 12. The state at this time is illustrated in FIGs. 9 to 11. FIG. 9 is a diagram illustrating a state in which board 23 is fixed to attachment part 12 by a screw. FIG. 10 is an enlarged diagram of region B of FIG. 9. Fig. 11 is a sectional diagram taken along the C-C line of FIG. 10.

As illustrated in FIGS. 9 to 11, screw 30 is inserted into hole portion 29 of board 23 and hole portion 21 (refer to FIG. 5) which is formed in joint portion 20 of attachment part 12, whereby board 23 is attached in contact with joint portion 20. Due to the screwing, as illustrated in FIG. 11, a portion of thermal conduction pattern 27 which is formed on board 23 and attachment part 12 (joint portion 20) are brought into close contact. Accordingly, the heat from attachment part 12 is easily conducted to thermal conduction pattern 27. Thermal conduction pattern 27 may be close to attachment part 12 (joint portion 20) without coming in contact with attachment part 12 (joint portion 20). In the present exemplary embodiment, board 23 is fastened to joint portion 20 by screw 30; however, the configuration is not limited thereto. For example, board 23 may be connected to joint portion 20 by a fixing method such as thermal caulking in which a boss is passed through the board and is welded using heat, an adhesive, or the like. Board 23 may be connected to joint portion 20 by another mechanical method.

When board 23 is screwed as described above, as illustrated in FIG. 11, thermistor 24 on board 23 is disposed to be separated from attachment part 21 (joint portion 20). As illustrated in FIG. 9, board 23 covers bus bar 15 and shunt resistance 17.

Due to this configuration, the heat of minus terminal 3 is conducted from attachment part 12 which is a portion of terminal 10 to thermal conduction pattern 27. The temperature of the head which is conducted to thermal conduction pattern 27 is detected by thermistor 24 which is close to thermal conduction pattern 27.

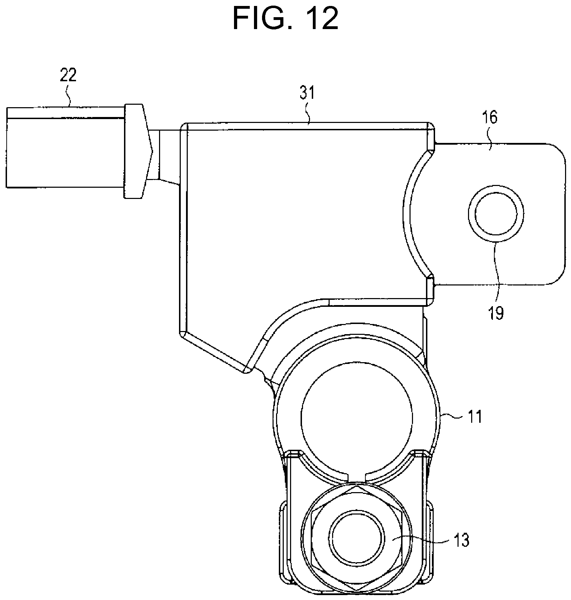

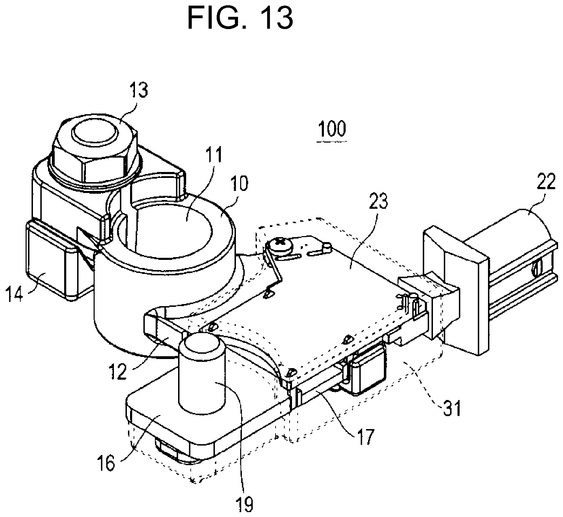

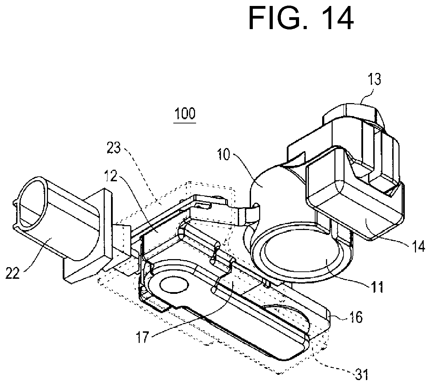

After board 23 is attached to attachment part 12 as described above, as illustrated in FIGS. 12, 13, and 14, resin mold 31 (an example of a sealer) is formed so as to cover board 23. Resin mold 31 prevents water droplets or the like from adhering to board 23.

Next, the range of the board fastening point (the fastening position between board 23 and joint portion 20) and the range of the disposition position of thermistor 24 will be described with reference to FIGS. 15 and 16. FIG. 15 is a diagram illustrating the range of the board fastening point. FIG. 16 is an enlarged diagram of region D in FIG. 15, which is a diagram for explaining the range of the disposition position of the thermistor.

First, description will be given of the range of the board fastening point using FIG. 15. In FIG. 15, O is the center of minus terminal 3 (or clamp part 11), and a is the radius of minus terminal 3. Further, b is the thickness of the electrode of clamp part 11, and c is the width (an example of the clearance distance) of the clearance between the side surface of clamp part 11 and resin mold 31. Further, d is the larger of the bearing surface diameter of screw 30 or the diameter (the length of a diagonal line) of the contact portion between board 23 and attachment part 12. Further, e is the distance from center O to the board fastening point (for example, the center of screw 30).

The values a to c described above are values which are determined based on requirements of manufacturability of battery 1 and terminal 10 (clamp part 11 and attachment part 12). The value d described above is a value which is arbitrarily changed based on the demand for accuracy in the measurement of the temperature.

In FIG. 15, it is ideal that the range of distance e from center O to the board fastening point is larger than a + b + c, and smaller than a + b + c + d. However, distance e to the board fastening point is a condition under which favorable characteristics may be obtained where distance e being larger than a + b + c, and smaller than a + b + c + 3d is a realistic range in consideration of component variation. Therefore, it is desirable for distance e to be defined by the following expression (1).

$$a + b + c < e < a + b + c + 3d \cdots (1)$$

In other words, the board fastening point is disposed outside first circle c1 and inside second circle c2 in FIG. 15. First circle c1 is a circle centered on point O and having the shortest distance (a + b + c) from point O to resin mold 31 as a radius. Second circle c2 is a circle with a distance (a + b + c + 3d) obtained by adding a length three times the maximum bearing surface width of screw 30 to the shortest distance a + b + c, or by adding a length three times the maximum width of the contact surface between board 23 and joint portion 20 to the shortest distance a + b + c as a radius.

Next, description will be given of the range of the disposition position of thermistor 24 using FIG. 16. In order to realize highly accurate temperature detection, it is desirable that the disposition position of thermistor 24 is as close as possible to the board fastening point which is described above. However, in consideration of installation variation, assembly variation, component crossing, and the like, as illustrated in FIG. 16, it is desirable that thermistor 24 is disposed in the range of a circle with radius 3d which is centered on point P (the center of screw 30) on the first surface of board 23. It is desirable that thermistor 24 is disposed in a position in this range at which thermistor 24 is less susceptible to the influence of the heat of shunt resistance 17.

As described above, according to battery sensor device 100 of the present exemplary embodiment, thermistor 24 is disposed on board 23 and is provided close to the fastening point between board 23 and terminal 10 (attachment part 12). Accordingly, battery sensor device 100 of the present exemplary embodiment may be easily assembled without using a lead wire, an elastic member, or the like, and may accurately detect the temperature of battery 1.

Although the first exemplary embodiment of the present invention is described to this point, the present invention is not limited to the above-described exemplary embodiment, and various modifications are possible.

For example, in the exemplary embodiment described above, a configuration is adopted in which thermal conduction pattern 27 is formed on board 23; however, thermal conduction pattern 27 may not be formed on board 23.

(Exemplary Embodiment 2)

Next, description will be given of exemplary embodiment 2. In the exemplary embodiment 2, in order to avoid a redundant explanation, mainly the differences from the first exemplary embodiment will be explained.

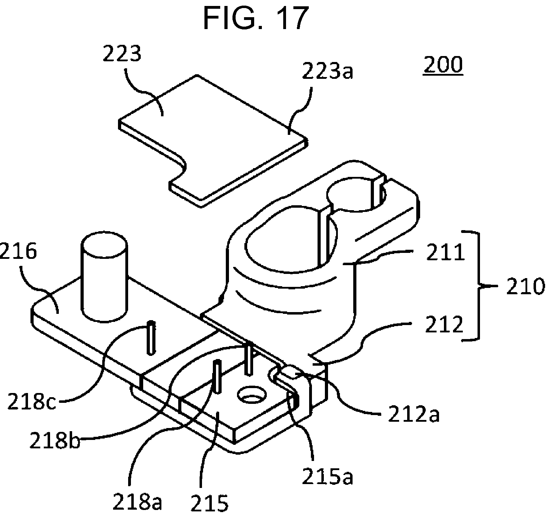

FIG. 17 is a perspective diagram illustrating the configuration of battery sensor device 200 according to exemplary embodiment 2 of the present invention. FIG. 17 illustrates the configuration of battery sensor device 200 before being covered by resin mold 231.

In FIG. 17, bus bar 215 is attached to terminal 210 (attachment part 212) in the same manner as in exemplary embodiment 1, and board 223 is provided on bus bar 215 in an overlapping manner.

Here, in the present exemplary embodiment 2, bus bar 215 includes cutout portion 215a.

Projection portion 212a (a portion of attachment part 212) which has a thickness in the height direction is formed on terminal 210, and when bus bar 215 is attached to terminal 210, projection portion 212a is present in a location corresponding to cutout portion 215a.

Board 223 includes protruding part 223a which protrudes from bus bar 215 toward the direction in which clamp part 211 is present, and when board 223 is caused to overlap bus bar 215, protruding part 223a is present on projection portion 212a (cutout portion 215a).

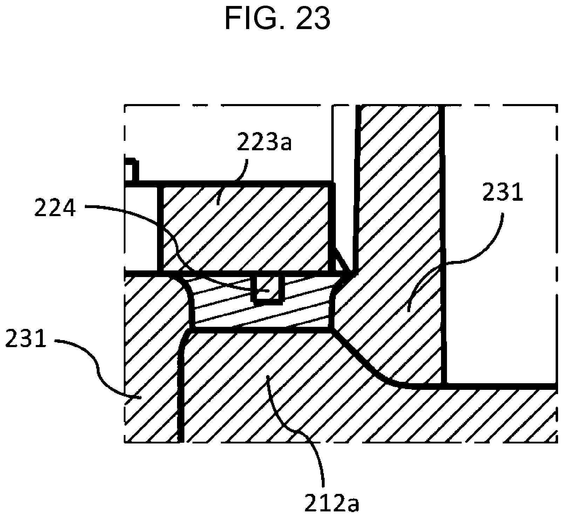

Thermistor 224 (temperature sensor) is installed on the bottom surface (the surface facing the bus bar) of protruding part 223a (refer to FIG. 23).

Here, in exemplary embodiment 1, resin mold 31 (an example of the sealer) is formed so as to cover board 223 after board 223 is fastened to attachment part 212 by screw 30.

On the other hand, in exemplary embodiment 2, resin mold 231 (an example of the sealer) is formed before board 223 is attached.

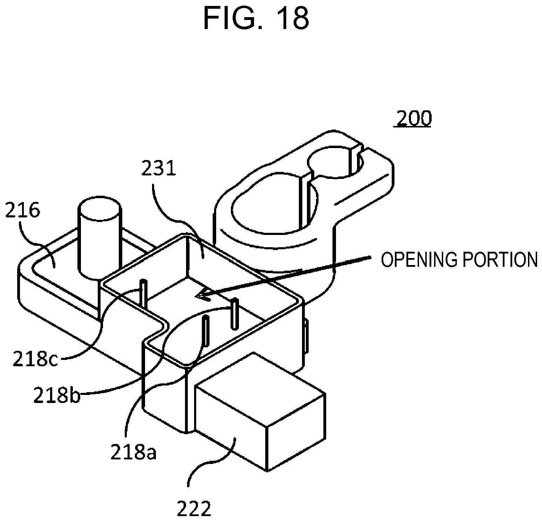

FIG. 18 is a perspective diagram illustrating the configuration of battery sensor device 200 after resin mold 231 is formed.

Resin mold 231 is formed so as to cover bus bar 215 and is molded integrally with connector portion 222.

Resin mold 231 is formed in a case shape, the top surface being opened on bus bar 215.

Current detection terminals 218a, 218b, and 218c of bus bars 215 and 216 protrude from the bottom surface at the opening portion of resin mold 231. Since bus bar 216 is equivalent to bus bar 16 which is described earlier, description thereof will be omitted.

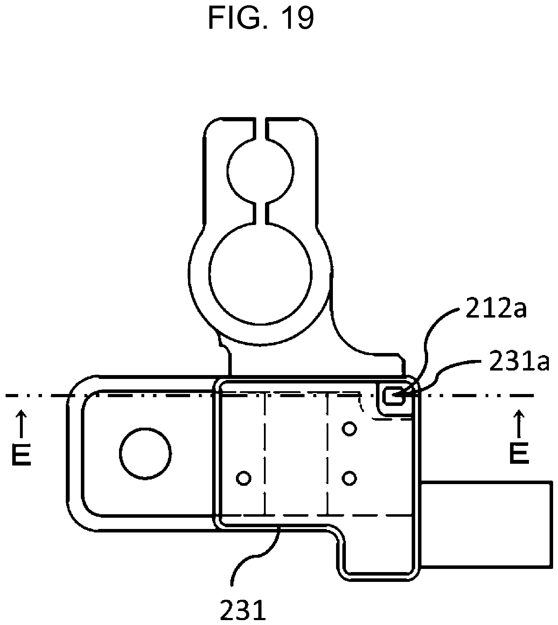

In addition, hole portion 231a (refer to FIG. 19) is formed in resin mold 231 such that only the top surface of projection portion 212a (cutout portion 215a of bus bar 215) is opened.

FIG. 19 is a top surface diagram illustrating the configuration of battery sensor device 200 after resin mold 231 is formed.

As illustrated in FIG. 19, hole portion 231a is formed by resin mold 231, and projection portion 212a is visible through hole portion 231a.

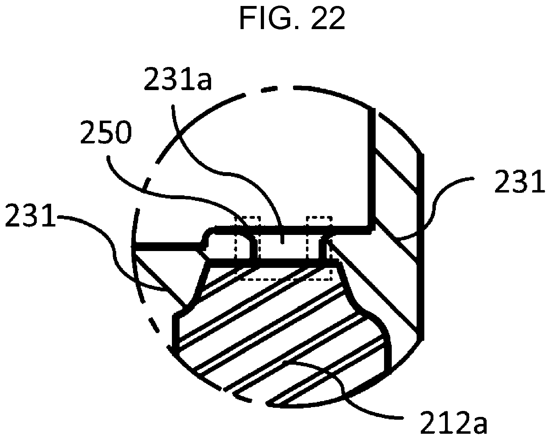

By forming resin mold 231, concave portion 250 with projection portion 212a as the bottom surface and resin mold 231 as the side walls is formed in a location corresponding to hole portion 231a (refer to FIG. 22).

Recess portion 250 which is formed is filled with a thermal grease (heat transfer member), and board 223 is caused to overlap the bus bar so as to be connected to current detection terminals 218a, 218b, and 218c.

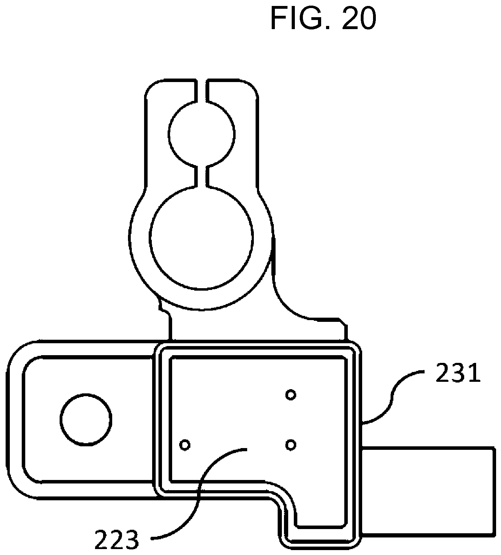

FIG. 20 is a top surface diagram illustrating the configuration of battery sensor device 200 after board 223 is caused to overlap.

As described above, board 223 is provided with protruding part 223a which corresponds to projection portion 212a (that is, cutout portion 215a and hole portion 231a).

Therefore, in FIG. 20, projection portion 212a (that is, cutout portion 215a and hole portion 231a) is covered by board 223 and may not be visually recognized.

Next, detailed description will be given of recess portion 250 which is formed by projection portion 212a and resin mold 231.

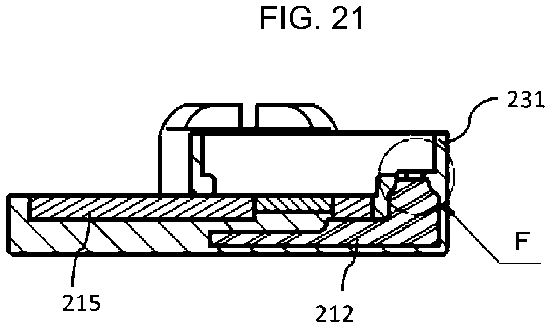

FIG. 21 is a sectional diagram taken along the E-E line of FIG. 19 (after molding, before board overlapping), and FIG. 22 is an enlarged diagram of region F in FIG. 21.

In FIG. 22, it is understood that by forming hole portion 231a, recess portion 250 (indicated by a dotted line) with projection portion 212a as the bottom surface and resin mold 231 as the side walls is formed.

Recess portion 250 is filled with the thermal grease (heat transfer member), and board 223 is subsequently caused to overlap.

FIG. 23 is a diagram illustrating a state after the thermal grease (heat transfer member) is filled, and board 223 is caused to overlap in FIG. 22.

As illustrated in FIG. 23, thermistor 224 which is provided on the bottom surface of protruding part 223a of board 223 sinks into the thermal grease with which recess portion 250 is filled.

Accordingly, thermistor 224 is capable of accurately measuring the temperature via projection portion 212a and the thermal grease.

Since thermistor 224 is not directly attached to terminal 210 but via the heat transfer member (thermal grease), there is a margin in the alignment of thermistor 224, and the ease of assembly is improved.

After board 223 is fixed by soldering or the like, the opening portion of resin mold 231 is covered by a lid or the like which is formed of resin, for example, such that the resin is molded.

As described above, according to battery sensor device 200 of the present exemplary embodiment 2, the thermal grease (heat transfer member) is caused to fill recess portion 250 which is formed by projection portion 212a of terminal 210 (attachment part 212) and resin mold 231, and thermistor 224 which is provided on board 223 sinks into the thermal grease. Accordingly, battery sensor device 200 of the present exemplary embodiment may be easily assembled, and may accurately detect the temperature of battery 1.

INDUSTRIAL APPLICABILITY

A battery sensor device according to the present invention may be applied to a battery or the like which is mounted on a vehicle, for example.

REFERENCE MARKS IN THE DRAWINGS

| | |
|---|---|
| 1 | battery |
| 2 | plus terminal |
| 3 | minus terminal |
| 10 | terminal |
| 11 | clamp part |
| 12 | attachment part |

| | |
|---|---|
| 12a | joint portion |
| 12b | hole portion |
| 12c | support portion |
| 13, 18 | bolt |
| 14 | nut |
| 15, 16 | bus bar |
| 15a | hole portion |
| 17 | shunt resistance |
| 18a, 18b, 18c, 18d | current detection terminal |
| 19 | vehicle load-side terminal |
| 20 | joint portion |
| 21 | hole portion |
| 22 | connector portion |
| 23 | board |
| 24 | thermistor |
| 25 | via |
| 26 | electric pattern |
| 27 | thermal conduction pattern |
| 28 | pattern cut portion |
| 29 | hole portion |
| 30 | screw |
| 31 | resin mold |
| 100, 200 | battery sensor device |
| 210 | terminal |
| 211 | clamp part |
| 212 | attachment part |
| 212a | projection portion |
| 215, 216 | bus bar |
| 215a | cutout portion |
| 218a, 218b, 218c | current detection terminal |
| 222 | connector portion |
| 223 | board |
| 223a | protruding part |
| 224 | thermistor |
| 231 | resin mold |
| 231a | hole portion |
| 250 | recess portion |

**Claims**

1. A battery sensor device comprising:

   a terminal which includes a clamp part which is fitted to a terminal of a battery;
   bus bars on one of which a load-side terminal is installed and which electrically connect the clamp part and the load-side terminal via a shunt resistance;
   a board which includes a protruding part which is electrically connected to the bus bars so as to overlap the bus bars and which protrudes toward the clamp part from the bus bars;
   a temperature sensor which is installed on the protruding part of a surface of the board which faces the bus bars; and
   a heat transfer member which is provided between the temperature sensor and the terminal.

2. The battery sensor device of Claim 1,
   wherein the terminal includes a projection portion at a location which corresponds to the temperature sensor,
   wherein the battery sensor device further includes a resin mold which forms a side wall such that a recess portion having the projection portion as a bottom surface is formed, and
   wherein the heat transfer member is provided in the recess portion.

**3.** A battery sensor device comprising:

a clamp part which is fitted to a terminal of a battery;
a load-side terminal;
bus bars which electrically connect the clamp part and the load-side terminal via a shunt resistance;
a temperature sensor which detects a temperature;
a board to which the temperature sensor is installed, and which is fastened to a metal part between the clamp part and the shunt resistance; and
a sealer which covers the board,
wherein the temperature sensor is installed on the board and separated from the metal part, and
wherein a fastener between the board and the metal part is disposed centered on a center of the clamp part, outside a first circle with a shortest distance as a radius from the center of the clamp part to the sealer, and inside a second circle centered on the center of the clamp part with a distance as a radius obtained by adding a length three times a maximum bearing surface width of the fastener, or a length three times a maximum width of a contact surface between the board and the metal part at the fastener, to a shortest distance from the center of the clamp part to the sealer.

**4.** The battery sensor device of Claim 3,
wherein the fastener is disposed separated from the center of the clamp part by e of a following expression (1), and

$$a + b + c < e < a + b + c + 3d \cdots (1)$$

wherein a is a radius of the terminal of the battery, b is a thickness of an electrode of the clamp part, c is a clearance distance from an outer circumferential surface of the clamp part to the sealer, and d is a larger of a bearing surface diameter of a screw which fastens the board to the metal part or a diameter of a contact portion between the board and the metal part.

**5.** The battery sensor device of Claim 3,
wherein the temperature sensor is disposed within a circle which is centered on a center of the fastener, and a radius of the circle is the length three times the maximum bearing surface width of the fastener, or the length three times the maximum width of the contact surface between the board and the metal part in the fastener.

**6.** The battery sensor device of Claim 3,
wherein the board includes a thermal conduction pattern, and
wherein the thermal conduction pattern extends along at least one side of the temperature sensor and is in contact with the metal part at the fastener, or extends along the metal part at the fastener.

**7.** The battery sensor device of Claim 3,
wherein the temperature sensor is installed on a surface of a side of the board that is in contact with the metal part.

# FIG. 1

# FIG. 2

EP 3 196 972 A1

# FIG. 3

12

# FIG. 4

# FIG. 5

# FIG. 6

# FIG. 7

# FIG. 8

# FIG. 9

# FIG. 10

# FIG. 11

# FIG. 12

# FIG. 13

FIG. 14

# FIG. 15

# FIG. 16

# FIG. 17

# FIG. 18

200

231

216

OPENING PORTION

218c

218b

218a

222

# FIG. 19

212a

231a

E

E

231

FIG. 20

231

223

# FIG. 21

## FIG. 22

# FIG. 23

223a

224

231

231

212a

## INTERNATIONAL SEARCH REPORT

| International application No. |
|---|
| PCT/JP2015/004540 |

| A. CLASSIFICATION OF SUBJECT MATTER |
|---|
| *H01M10/48*(2006.01)i, *G01K1/14*(2006.01)i, *G01R15/14*(2006.01)i, *G01R31/36*(2006.01)i |

According to International Patent Classification (IPC) or to both national classification and IPC

| B. FIELDS SEARCHED |
|---|

Minimum documentation searched (classification system followed by classification symbols)
H01M10/48, G01K1/14, G01R15/14, G01R31/36

Documentation searched other than minimum documentation to the extent that such documents are included in the fields searched
Jitsuyo Shinan Koho        1922-1996   Jitsuyo Shinan Toroku Koho   1996-2015
Kokai Jitsuyo Shinan Koho   1971-2015   Toroku Jitsuyo Shinan Koho   1994-2015

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| Y<br>A | JP 2003-517613 A (Bayerische Motoren Werke AG),<br>27 May 2003 (27.05.2003),<br>paragraphs [0009], [0011] to [0012]; fig. 2 to 4, 7<br>& US 2003/0057770 A1<br>paragraphs [0020], [0022] to [0023]; fig. 2 to 4, 7<br>& WO 2001/044825 A1      & EP 1435524 A1<br>& DE 19961311 A | 1-2<br>3-7 |
| Y | JP 2012-78328 A (Yazaki Corp.),<br>19 April 2012 (19.04.2012),<br>paragraphs [0028] to [0031]; fig. 1 to 4, 8<br>(Family: none) | 1-2 |

| ☒ Further documents are listed in the continuation of Box C. | ☐ See patent family annex. |
|---|---|

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>12 November 2015 (12.11.15) | Date of mailing of the international search report<br>24 November 2015 (24.11.15) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

**INTERNATIONAL SEARCH REPORT**

| International application No. |
| --- |
| PCT/JP2015/004540 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2012-220249 A  (Yazaki Corp.),<br>12 November 2012 (12.11.2012),<br>paragraphs [0026] to [0028]; fig. 1, 5<br>& US 2014/0015515 A1<br>paragraphs [0039] to [0041]; fig. 1, 5<br>& WO 2012/137980 A1      & EP 2694985 A1 | 1-2 |
| A | JP 2009-177903 A  (Denso Corp.),<br>06 August 2009 (06.08.2009),<br>entire text; all drawings<br>& US 2009/0184683 A1<br>entire text; all drawings<br>& DE 102009004447 A      & CN 101494392 A | 1-7 |

Form PCT/ISA/210 (continuation of second sheet) (July 2009)

**EP 3 196 972 A1**

## REFERENCES CITED IN THE DESCRIPTION

### Patent documents cited in the description

- JP 4494895 B

- JP 4996802 B